# EUROPÄISCHE PATENTSCHRIFT

(11) **EP 0 603 909 B1**
(45) Veröffentlichungstag und Bekanntmachung des Hinweises auf die Patenterteilung: **03.02.1999**
(21) Anmeldenummer: 93120870.6
(22) Anmeldetag: 24.12.1993
(51) Int. Cl.: H03H 7/46

(54) **Hochfrequenz-Rohrkernübertrager**
Microwave tubular core transformer
Transformateur hyperfréquent comportant un noyau tubulaire

(30) Priorität: 24.12.1992 DE 4244107
(43) Veröffentlichungstag der Anmeldung: 29.06.1994
(73) Patentinhaber: Richard Hirschmann GmbH & Co., 72654 Neckartenzlingen (DE)
(72) Erfinder: Wendel, Wolfgang, D-73257 Köngen (DE); Epple, Ralf, D-73249 Wernau (DE)
(74) Vertreter: Stadler, Heinz, Dipl.-Ing.

(56) Entgegenhaltungen:
- EP-A- 0 126 169
- WO-A-85/00072
- DE-A- 2 603 358
- IBM TECHNICAL DISCLOSURE BULLETIN. Bd. 28, Nr. 2 , Juli 1985 , NEW YORK US Seiten 625 - 626 'Slit-plate transformer'

## Beschreibung

Die Erfindung betrifft einen Hochfrequenz-Übertrager gemäß dem Oberbegriff des Anspruches 1. Ein solcher Hochfrequenz-Übertrager ist aus der EP-A-0 126 169 bekannt.

Ferner ist ein Hochfrequenz-Rohrkernübertrager beispielsweise aus der EP-A-0 134 950 bekannt. Im VHF/UHF-Bereich bis ca. 860 MHz sind solche Rohrkernübertrager mit ausreichend guten elektrischen Übertragungskennwerten ohne größere Schwierigkeiten realisierbar, weil durch relativ große Kerndurchmesser die Toleranzprobleme in der Fertigung gering sind.
Für Anwendungen im ersten Satelliten-ZF-Bereich bis 1,75 GHz sind wegen der Streuinduktivitäten und der Eigenresonanz der Übertrager infolge der notwendigen Masseumrandung der Wicklungsplatine deutlich kleinere Rohrkerne erforderlich, um zufriedenstellende elektrische Daten, insbesondere eine geringere Durchgangsdämpfung zu erhalten. Dadurch müssen die Druckplatinen wesentlich präziser mit stark verringerten Toleranzen hergestellt werden mit der Folge höherer Material- und Fertigungskosten.

Bei zukünftig benötigten Hochfrequenz-Schaltungen für den Satellitenempfang in einem bis etwa 3 GHz erweiterten ersten Satelliten-ZF-Bereich (z.B. durch Inbetriebnahme des Satelliten ASTRA 1D) reichen jedoch die genannten Maßnahmen nicht aus, um brauchbare Werte für die Rückflußdämpfungen und die Durchgangsdämpfung zu erhalten.

Der bekannte Hochfrequenz-Rohrkernübertrager weist darüberhinaus den Nachteil auf, daß neben der eigentlichen Schaltungsplatine (Trägerplatine) eine zusätzliche Wicklungsplatine für den Übertrager nötig ist, die in Ausnehmungen der Trägerplatine eingesteckt werden muß ("Stecktrafo"). Für den elektrischen Anschluß sind außerdem die Leiterbahnen der beiden Platinen durch Lötung zu verbinden, sodaß der bekannte Aufbau auch einen hohen Materialaufwand sowie eine komplizierte, nicht ohne besondere Vorrichtungen für maschinelle Montage geeignete und damit teuere Fertigung bedingt.

Der Erfindung liegt daher die Aufgabe zugrunde, einen Hochfrequenz-Rohrkernübertrager der eingangs genannten Art zu schaffen, der breitbandig bis etwa 3 GHz gute elektrische Ubertragungskennwerte aufweist, einfach und materialsparend aufgebaut sowie kostengünstig fertigbar ist.

Diese Aufgabe ist erfindungsgemäß durch die kennzeichenden Merkmale des Anspruches 1 gelöst.
Die Übertragerwicklungen sind im Druckbild der Trägerplatine enthalten. Bei der Fertigung werden lediglich die Schenkel einer Halbschale durch die zugehörigen Ausnehmungen in der Trägerplatine gesteckt, die Halbschalen zusammengefügt und die Trägerplatine bestückt sowie gelötet.
Durch die Integration des Übertragers in die Trägerplatine, also den Wegfall einer getrennten Wicklungsplatine, ist bereits der Aufbau dieses Übertragers erheblich einfacher und kostengünstiger. In besonderem Maße ist dieser Vorteil aber bei der Fertigung gegeben, weil die Herstellung einer gesonderten Platine, deren Montage auf der Trägerplatine sowie die Lötverbindung der zugehörigen Leiterbahnen der beiden Platinen entfällt und die Fertigung ohne weiteres maschinell, z.B. in SMD-Technik, erfolgen kann. Die Trägerplatine kann dabei einseitig oder doppelseitig beschichtet, aber auch in Multilayer-Technik aufgebaut sein.
Darüberhinaus sind durch den erfindungsgemäßen Aufbau minimale Leitungslängen der als Leiterbahnen ausgebildeten HF-Verbindungen und Wicklungen ermöglicht, wodurch die elektrischen Daten des Rohrkern-Übertragers, insbesondere die Durchgangsdämpfung, zu hohen Frequenzen hin wesentlich verbessert werden.

Weiterhin ist der Platzbedarf der Trägerplatine in der Höhe im Vergleich zum aus der EP-A-0 134 950 bekannten Stand der Technik, bei dem der Stecktrafo senkrecht von der Trägerplatine abragt, fast um die Höhe des Stecktrafos geringer. Dadurch ist nicht nur ein kleineres Gehäuse für das den bzw. die Rohrkernübertrager aufweisende Gerät (z.B. Richtkoppler-Abzweiger) möglich, vielmehr reduziert sich beispielsweise auch die Länge der Verbindungsleitung(en) zu der (den) zugehörigen Klemme(n) und damit deren störende Induktivität, sodaß mit dieser räumlichen Verkleinerung auch eine Erhöhung der oberen Grenzfrequenz verbunden ist.
Da für den Anschluß der Wicklungsleiterbahnen des erfindungsgemäßen Rohrkernübertragers an diejenigen der Trägerplatine keine Lötstellen mehr erforderlich sind, können die Leiterbahnen durchgehend sehr dünn ausgeführt sein. Die damit erzielte geringere Windungskapazität und der Entfall von durch Lötpads verursachten zusätzlichen Störkapazitäten bewirkt eine weitere Erhöhung der oberen Grenzfrequenz.

Beim Zusammenfügen der Rohrkern-Halbschalen verbleibt ein zumindest in der Größenordnung der Oberflächenrauhigkeit und der mechanischen Fertigungstolerenanzen liegender Luftspalt zwischen den Stirnflächen. Überraschenderweise ist die Gesamtinduktivität (A_{L}-Wert) des Rohrkerns trotz dieses Spaltes auch für tiefe Frequenzen ausreichend. Messungen haben ergeben, daß für Frequenzen oberhalb etwa 40 MHz die Wirkung des Luftspalts unwesentlich ist und der A_{L}-Wert lediglich bei Frequenzen unterhalb des Übertragungsbereiches stark abfällt. Bei diesen tiefen Frequenzen stellen die Übertragerwicklungen praktisch Kurzschlüsse dar, weshalb für diesen Bereich in an sich bekannter Weise Widerstände bzw. Widerstandsnetzwerke für die Signalübertragung vorgesehen sind.
Bei den hier vor allem interessierenden sehr hohen Frequenzen des ersten Satelliten-ZF-Bereiches bewirkt der Luftspalt durch geringere Kernverluste gegenüber homogen geschlossenen Rohrkernen eine Verringerung des Verlustwiderstandes und damit der Durchgangsdämpfung.

Vorteilhafte Ausführungen bzw. Ausgestaltungen des Gegenstandes nach dem Anspruch 1 sind den Unteransprüchen zu entnehmen.
Die mechanische Verbindung der Rohrkern-Halbschalen kann grundsätzlich auf beliebige Weise (z.B. durch eine Klammer) erfolgen. Vorteilhaft ist es jedoch, gemäß Anspruch 2 die einander zugewandten Stirnflächen miteinander zu verkleben. Eine solche Verbindung ist kostengünstig, weist durch einfache Wahl des Klebers die im Einzelfall erforderliche Haltekraft auf und hat keine störenden Auswirkungen auf den magnetischen Fluß.
Die Fertigung ist besonders kostengünstig, wenn die Verklebung der Halbschalen maschniell, beispielsweise mittels eines SMD-Automaten, erfolgt (Anspruch 3). Dabei werden in der Klebestation die Stirnflächen der ersten, relativ zur Trägerplatine fixierten Halbschale ebenso mit Klebepunkten versehen, wie die Trägerplatine an den für SMD-Bauteile vorgesehenen Stellen. Anschließend erfolgt die Bestückung mit SMD-Bauteilen und im selben Fertigungsschritt auch das Aufpressen der zweiten Halbschale auf die erste mittels eines Bestückungskopfes. Durch den Aufpreßdruck wird der Kleber bis auf eine sehr dünne Schicht (z.B. 0,05 mm) zusammengepreßt. Nach der Trocknung im Ofen wird schließlich die Platine im Schwallbad oder in Reflow-Technik gelötet.

Durch Wahl einer entsprechenden Menge des Klebers und/oder durch Positionierung wenigstens eines weiteren Klebepunktes in der Randzone der Stirnflächen der ersten Rohrkern-Halbschale (Anspruch 4) wird praktisch ohne Mehrkosten erreicht, daß ein Teil des Klebers seitlich aus dem Spalt zwischen den Stirnflächen austritt und auf diese höchst einfache Weise den Rohrkern an der Trägerplatine fixiert.

Eine besonders zweckmäßige Anordnung der ersten Rohrkern-Halbschale besteht nach Anspruch 5 darin, daß deren Stirnfläche mit der Oberfläche der Bestückungsseite der Trägerplatine bündig ist. Dadurch liegen alle Klebepunkte in einer Ebene, so daß beim SMD-Verfahren die die Klebepunkte setzende Dosiernadel senkrecht zur Platine immer die gleiche Auslenkung durchzuführen hat und ihre Steuerung damit sehr einfach ist.
Eine weitere Vereinfachung bei einer Fertigung in SMD-Technik ist durch eine Ausführung der Halbschalen nach Anspruch 6 erzielt, da die jeweils im Scheitelbereich vorgesehenen Abflachungen eine günstige Fixierung und Positionierung der Rohrkern-Halbschalen durch einfache Haltemittel bzw. Zuführungswerkzeuge (Saugpipette) ermöglichen.

Durch eine Ausbildung der Rohrkerne gemäß Anspruch 7 ist der Vorteil erreicht, daß der im Inneren des Rohrkerns liegende Teil der Trägerplatine eine maximale Breite aufweisen kann, weil er bei entsprechender Bemessung in seiner ganzen Stärke (und nicht nur mit der Ober- und Unterkante) an dem geraden Teil der Kernschenkel anliegt. Dadurch ist entweder eine große Zahl von Leiterbahnen möglich oder ein größerer gegenseitiger Abstand der Leiterbahnen und damit eine höhere obere Grenzfrequenz aufgrund der verringerten Windungskapazität.

Die Halbschalen können prinzipiell einen beliebigen Querschnitt aufweisen. Ein zylindrischer Kern (Anspruch 8) hat den Vorteil, daß er kostengünstig in der Herstellung ist und zugleich einen ausreichenden Abstand zu allen ihn durchsetzenden Leiterbahnen gewährleistet, womit eine weitere Erhöhung der oberen Grenzfrequenz aufgrund einer geringeren Windungskapazität erzielt ist. Selbst bei hochpermeablen Kernmaterialien ist überdies auch ohne Schutzlack ein Windungskurzschluß sicher vermieden.

Durch den erfindungsgemäßen zweiteiligen Aufbau des Rohrkerns ist es gemäß Anspruch 9 in vorteilhafter Weise möglich, für die beiden Halbschalen unterschiedliche Kernmaterialien zu wählen. Damit kann ein spezielles, auf die Bedürfnisse des Einzelfalles abgestimmtes Breitbandverhalten bzw. ein gezielter Dämpfungverlauf über die Frequenz realisiert werden. Durch die geeignete Wahl der relativen Permeabilität der Halbschalen bzgl. der unteren und oberen Grenzfrequenz lassen sich für jeden Teilfrequenzbereich optimale elektrische Daten erreichen.

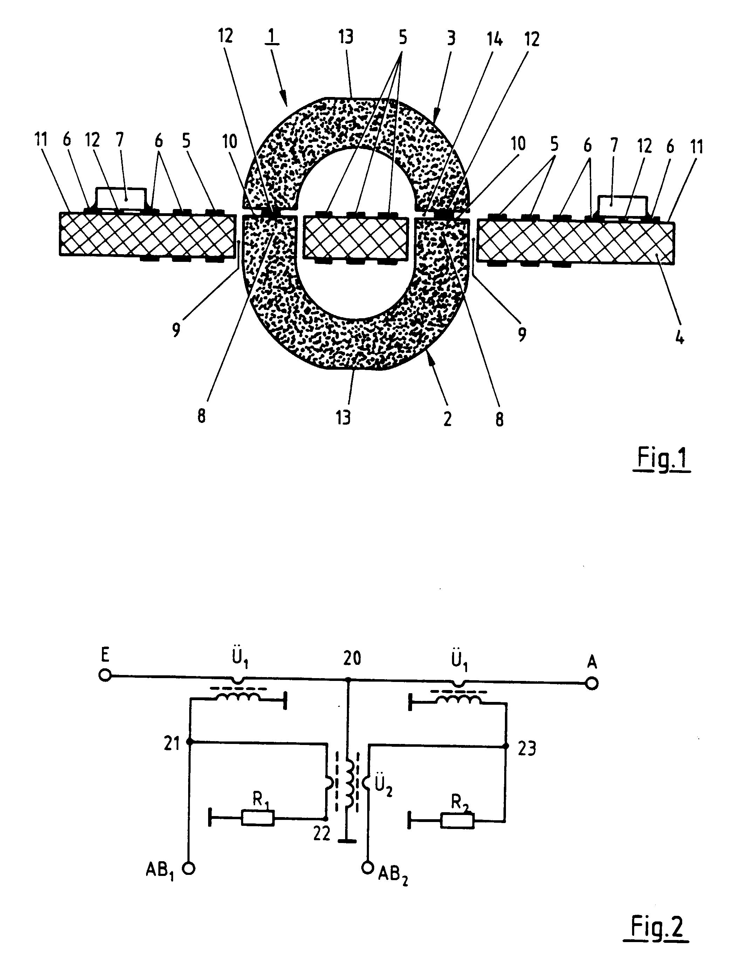

Die Erfindung ist selbstverständlich nicht auf Rohrkerne mit nur einer Ausnehmung beschränkt. Vielmehr kann es im Einzelfall vom Platzbedarf und den Kosten her vorteilhaft sein, gemäß Anspruch 10 einen Mehrlochkern zu verwenden.
Durch den vorgegebenen Durchmesser der Rohrkernbohrung und die damit bestimmte maximale Breite des hindurchgeführten Platinenteils einerseits sowie deren im Hinblick auf schädliche Koppelkapazitäten erforderlichen gegenseitigen Mindestabstand andererseits ist die Anzahl der darauf anordenbaren Leiterbahnen und somit auch die erreichbare Auskoppeldämpfung begrenzt.
Eine Ausgestaltung der Erfindung gemäß den Ansprüchen 10 und 11 ermöglicht auf höchst einfache und kosten- sowie platzsparende Weise eine fast beliebige Erhöhung des Windungszahlenverhältnisses und damit der Auskoppeldämpfung und der oberen Grenzfrequenz. Beim Ausführungsbeispiel gemäß den Fig. 2 bis 4 beträgt z.B. das Windungszahlenverhältnis des Übertragers Ü₂ 4:1, wobei die Sekundärwicklungen jeweils aus einer den Rohrkern durchsetzenden Leiterbahn besteht. Wird nun beispielsweise die Ausnehmung oder der Trennspalt etwa in der Mitte der Halbschale angeordnet und die Sekundärwindung bereits an dieser Stelle aus dem Rohrkern herausgeführt, so ist ihr im Rohrkern verlaufender Teil nur noch halb so lang, das Windungszahlenverhältnis bei gleicher Anzahl der Primärwicklungsleiterbahnen entspricht also 8:1 und die Auskoppeldämpfung damit bei gleichzeitiger Erhöhung der oberen Grenzfrequenz von etwa 14 dB auf ca. 20 dB gestiegen. Durch die gleiche Anzahl der den Rohrkern durchsetzenden Leiterbahnen hat sich deren gegenseitiger Abstand dabei nicht verringert und somit die schädliche Koppelkapazität nicht erhöht.

Bei einer Trennung der Halbschalen gemäß Anspruch 11 ist es darüberhinaus möglich, durch Verwendung von Halbschalenteilen mit unterschiedlicher relativer Permeabilität (entspr. Anspruch 9) das Breitbandverhalten wesentlich zu verbessern. Besonders zweckmäßig ist es hierbei, die Signale unterschiedlicher Frequenzbereiche nach Anspruch 12 auszukoppeln. Durch die hohe relative Permeabilität µ_{R} ist bei tiefen Frequenzen eine ausreichende Rückflußdämpfung gewährleistet, während bei hohen Frequenzen durch den niedrigen µ_{R}-Wert geringe Verluste erreicht sind. Ein derartiger Aufbau ist z.B. besonders sinnvoll bei einem als Antennensteckdose verwendeten Richtkopplerabzweiger gemäß Fig. 2, bei dem an einem Abzweig die TV-und am anderen Abzweig die RF-Signale entnommen werden.

Die Erfindung wird nachstehend noch anhand einer Prinzipdarstellung und eines praktischen Ausführungsbeispiels näher erläutert. Es zeigen:
- Figur 1 -: die schematische Darstellung der Anordnung eines Hochfrequenz-Rohrkernübertragers in einer SMD-bestückten Schaltungsplatine in stirnseitiger vergrößerter Ansicht,
- Figur 2 -: das Prinzipschaltbild einer Antennensteckdose mit einem den erfindungsgemäßen Rohrkernübertrager mehrfach enthaltenden Doppel-Richtkopplerabzweiger,
- Figuren 3,4 -: die beiden Seiten der Trägerplatine der realisierten Antennensteckdose gemäß der Schaltung nach Figur 2 in Draufsicht, wobei die ersten Halbschalen der Rohrkerne dargestellt sind,
- Figuren 5a-c -: perspektivische Ansichten eines Rohrkerns (in Fig. 5a mit Trägerplatine) gemäß den Ausführungen nach den Ansprüchen 10 bis 12 und
- Figur 6 -: eine Prinzipdarstellung der Schaltung gemäß Fig. 2 mit einem Rohrkernaufbau nach Fig. 5c.

Der in Figur 1 dargestellte Prinzipaufbau zeigt einen HF-Rohrkernübertrager 1, dessen aus zwei Halbschalen 2, 3 bestehender Rohrkern in der Ebene einer doppelseitig kaschierten Trägerplatine 4 angeordnet ist, die eine Anzahl Wicklungsleiterbahnen 5 und Verbindungsleiterbahnen 6 sowie SMD-Bauteile, z.B. ohm'sche Widerstände 7 trägt. Der ovale Rohrkern durchsetzt mit den längeren, gerade ausgebildeten Schenkeln 8 der ersten Halbschale zwei Ausnehmungen 9 der Trägerplatine 4.

Bei der Bestückung der Trägerplatine 4 in SMD-Technik wird zunächst die erste Halbschale 2 des Rohrkerns in einer nicht dargestellten Haltevorrichtung so fixiert, daß ihre Stirnflächen 10 mit der Bestückungsfläche 11 der Trägerplatine 4 bündig sind. Danach werden in der Klebestation sowohl die Rohrkernstirnflächen 10 der Halbschalen 2 als auch die Stellen der Trägerplatine 4, an denen SMD-Bauteile 7 vorgesehen sind, mit Klebepunkten 12 versehen. Anschließend erfolgt die SMD-Bestückung mittels eines Bestückungskopfs (Saugpipette); in diesem Fertigungsschritt werden zugleich die Widerstände 7 und die zweite Halbschale 3 auf die zugehörigen Klebepunkte 12 aufgedrückt. Die Scheitelabschnitte 13 der beiden Rohrkernhalbschalen 2, 3 sind abgeflacht ausgeführt, wodurch sowohl die Haltevorrichtung für die erste Halbschale 2 als auch die Saugpipette zur Positionierung der zweiten Halbschale 3 einfacher und kostengünstiger ausgebildet sein können.

Durch den Aufpreßdruck bei der Bestückung wird der Klebstoff der Klebepunkte 11 bis auf eine dünne zwischen den Stirnflächen 10 der Halbschalen 2, 3 verbleibende Schicht zusammengepreßt und damit der Spalt 14 zwischen den Stirnflächen 10 minimiert. Die Klebstoffmenge ist dabei so bemessen, daß ein Teil davon seitlich aus dem Spalt 14 austritt und den Rohrkern ohne einen zusätzlichen Arbeitsgang an der Schaltungsplatine 4 befestigt. Nach der Trocknung im Ofen kann die bestückte Trägerplatine 4 im Schwallbad gelötet werden.

Durch seine erfindungsgemäße Zweiteilung kann der Rohrkern auf einfache Weise in der Schaltungsplatine selbst angeordnet werden, sodaß im Gegensatz zum Stand der Technik eine gesonderte Wicklungsplatine ebensowenig mehr nötig ist wie die (Löt-)Verbindung der Leiterbahnen von Wicklungs-und Trägerplatine. Dadurch ist nicht nur eine besonders einfache und kcstengünstige maschinelle Fertigung und ein Gehäuse geringer Bauhöhe ermöglicht; vielmehr sind aufgrund der kürzestmöglichen Leitungslänge der Verbindungen und Wicklungen, des Entfalls von Lötpads in den Wicklungen, der geringen Windungskapazität durch größtmöglichen gegenseitigen Abstand der Wicklungsleiterbahnen und den durch den Spalt verminderten Verlustwiderstand breitbandig gute elektrische Ubertragungskennwerte, insbesondere eine geringe Durchgangsdämpfung, von ca. 40 MHz bis hinauf zu etwa 3 GHz erzielt.
In an sich bekannter Weise kann durch den Klebespalt auch die Aussteuergrenze erhöht werden, ein Vorteil, der bei HF-Leistungstrafos oder stromdurchflossenen Obertragern von Bedeutung ist.

Erfindungsgemäße HF-Rohrkernübertrager sind mit Vorteil z.B. bei gemäß Figur 2 aufgebauten Antennendurchgangssteckdosen einsetzbar, weil sich durch deren Hintereinanderschaltung die Wirkung der niedrigen Durchgangsdämpfung bis zur Obergrenze des derzeit geplanten erweiterten ersten Satelliten-Zwischenfrequenzbereiches summiert, sodaß mit derartigen Antennensteckdosen wesentlich längere Stammleitungen (mehr Teilnehmer) ohne zusätzliche Verstärker realisierbar sind.

Bei der dargestellten, bereits in der DE 30 28 683 C2 näher beschriebenen Prinzipschaltung sind zwischen dem Stammleitungseingang E und dem Stammleitungsausgang A zwei jeweils einen Stromübertrager Ü₁ und einen Spannungsübertrager Ü₂ sowie einen internen Abschlußwiderstand R₁, R₂ aufweisende Richtkopplerabzweiger hintereinandergeschaltet, wobei der erste die Eingangsimpedanz zu niedrigeren Werten herabtransformiert und der zweite sie zu Kompensationszwecken wieder hochtransformiert. Dabei sind die beiden Spannungsübertrager durch Verwendung von nur einer für beide wirksamen Primärwicklung zu einem einzigen Spannungsübertrager Ü₂ zusammengefaßt. An den beiden Abzweiganschlüssen AB₁ und AB₂ liegt jeweils der gesamte Übertragungsfrequenzbereich an; soll jedoch der eine Anschluß (AB₁) nur für Rundfunkempfang, der andere (AB₂) nur für TV-Empfang vorgesehen sein, so ist dies auf einfache Weise durch Nachschalten entsprechender Filter möglich, (siehe Figur 7 der DE 30 26 683 C2).

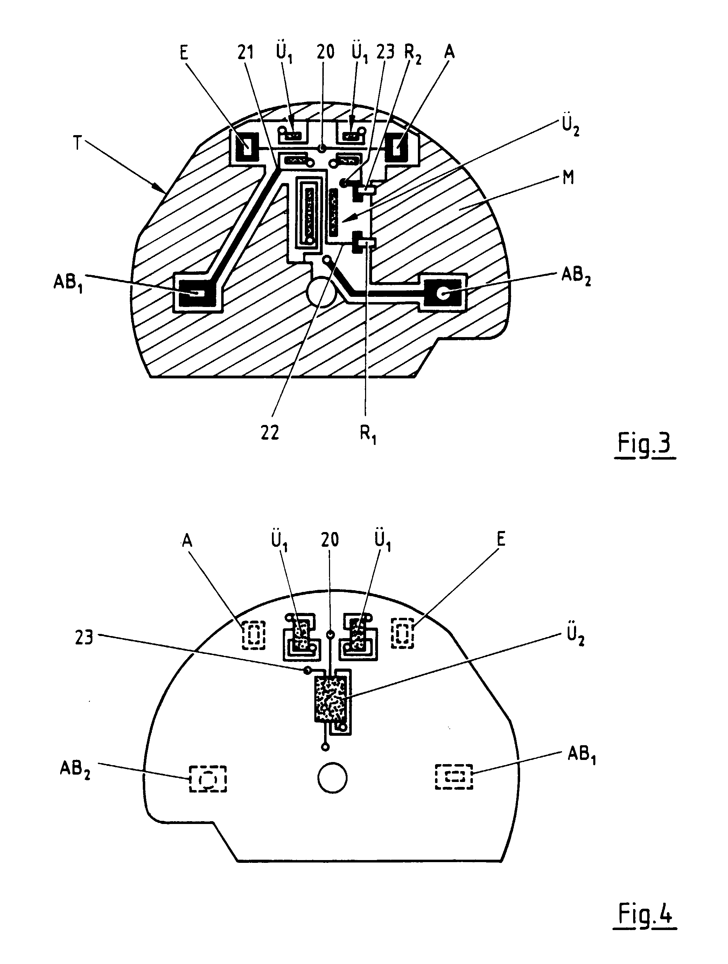

Diese Schaltung ist auf einer doppelseitig kaschierten Trägerplatine T mit Massefläche M gemäß den Figuren 3 und 4 realisiert, wobei die durch kleine Ringe markierten Stellen Durchkontaktierungspunkte bezeichnen und die im übrigen verwendeten Buchstaben und Ziffern (20 bis 24) denen in Figur 2 entsprechen.

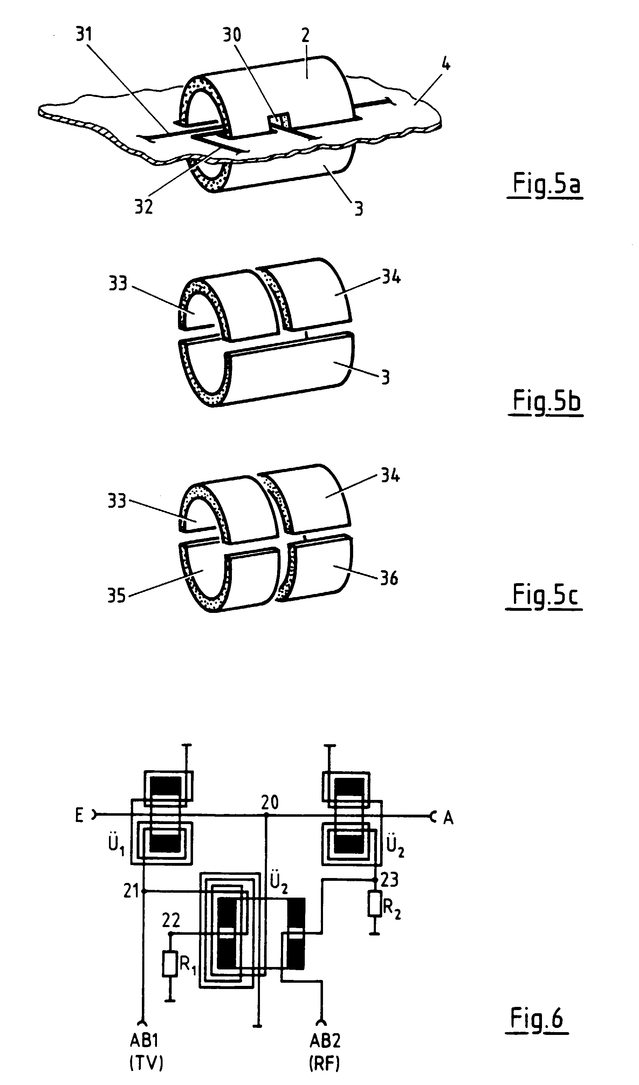

Die Halbschalen 2,3 der Rohrkerne können gemäß Anspruch 10 Auslässe zum Herausführen einer Wicklungsleiterbahn aufweisen, um dadurch eine Wicklung zu verkürzen und entsprechend das Windungszahlenverhältnis zu erhöhen.
Dazu sind in den Figuren 5 a bis c drei verschiedene Möglichkeiten aufgezeigt. Im einfachsten Fall (Figur 5a) weist die die Trägerplatine 4 durchdringende Halbschale 2 eine etwa in der Mitte des Rohrkerns angebrachte Ausnehmung 30 quer zur Rohrkernachse auf. Die durchgehende Leiterbahn 31 ist eine Windung der Primärwicklung des Übertragers Ü₂ (die anderen drei durchgehenden Leiterbahnen verlaufen auf der Rückseite der Trägerplatine 4), die aus der Ausnehmung 30 herausgeführte Leiterbahn 32 ist eine der Sekundärwicklungen. Durch die Reduzierung der Länge der den Rohrkern durchsetzenden Sekundärwicklung 32 auf die Hälfte ist das entsprechende Windungszahlenverhältnis verdoppelt und die Auskoppeldämpfung damit unter gleichzeitiger Erhöhung der oberen Grenzfrequenz um etwa 6 dB erhöht.

Anstelle der Ausnehmung 30 kann eine vollständige Trennung der Halbschale(n) 2 (3) in Halbschalenteile 33, 34 (35, 36) vorgesehen werden. Ein derartiger Aufbau bietet über die genannten Vorteile hinaus die Möglichkeit, Halbschalenteile 33, 34 (35, 36) mit unterschiedlichen relativen Permeabilitätskonstanten einzusetzen und damit eine hohe Breitbandigkeit dieser Rohrkernübertrager zu erzielen.

Darüberhinaus ist es bei der Übertragung eines höheren und eines tieferen Frequenzbereiches zweckmäßig, die Signale des höheren Frequenzbereiches über ein Halbschalenteil 33 (35) mit der geringeren und die Signale des tieferen Frequenzbereichs über das Halbschalenteil 34 (36) mit der höheren relativen Permeabilitätskonstanten auszukoppeln. Dies ist in der in Figur 6 dargestellten Schaltung erfolgt, weshalb der Abzweiganschluß AB 1 für den TV-Anschluß, der Abzweiganschluß AB 2 für den RF-Anschluß vorgesehen ist.

## Patentansprüche

1. Hochfrequenz-Übertrager mit in Drucktechnik ausgeführten Übertragerwicklungen für auf kaschierten Trägerplatinen angeordnete gedruckte Hochfrequenz-Schaltungen, insbesondere für Gemeinschafts-Antennenanlagen, der einen mit Schenkeln je eine Ausnehmung der Trägerplatine durchsetzenden zweigeteilten Ferritkern aufweist, dessen Teile mechanisch miteinander verbunden sind,
**dadurch gekennzeichnet,** daß der Ferritkern als Rohrkern mit zwei Halbschalen (2, 3) ausgebildet ist, die durch einen zwischen ihren einander zugewandten Stirnflächen (10) gebildeten dünnen Spalt (14) von einander getrennt sind, dessen Stärke so bemessen ist, daß bei hohen Frequenzen bis etwa 3 GHz der Verlustwiderstand verringert, bei tiefen Frequenzen oberhalb etwa 40 MHz jedoch die Gesamtinduktivität nur unwesentlich beeinflußt ist.

2. Rohrkernübertrager nach Anspruch 1, **dadurch gekennzeichnet,** daß die einander zugewandten Stirnflächen (10) der Halbschalen (2, 3) miteinander verklebt sind.

3. Rohrkernübertrager nach Anspruch 2, **dadurch gekennzeichnet,** daß die Verklebung maschinell im Rahmen einer SMD-Bestückung erfolgt.

4. Rohrkernübertrager nach Anspruch 2 oder 3, **dadurch gekennzeichnet,** daß der Klebstoff (12) in der Menge oder Positionierung so gewählt ist, daß ein Teil davon beim Zusammenfügen der Halbschalen (2, 3) über den äußeren und/oder inneren Rand der Stirnflächen (10) der Halbschalen (2, 3) hinaustritt und eine Klebeverbindung des Rohrkerns mit der Trägerplatine (4) herstellt.

5. Rohrkernübertrager nach einem der Ansprüche 2 bis 4, **dadurch gekennzeichnet,** daß die Stirnfläche (10) einer Halbschale (2) bündig ist mit der Oberfläche (11) der Bestückungsseite der Trägerplatine (4), auf der SMD-Bauteile (7) angeordnet sind.

6. Rohrkernübertrager nach einem der Ansprüche 1 bis 5, **dadurch gekennzeichnet,** daß die Außenfläche der Halbschale (2, 3) im Scheitelbereich jeweils einen ebenen Abschnitt (13) aufweist.

7. Rohrkernübertrager nach einem der Ansprüche 1 bis 6, **dadurch gekennzeichnet,** daß die Schenkel (8) einen geraden Bereich aufweisen, dessen Länge zumindest der Stärke der Trägerplatine (4) entspricht.

8. Rohrkernübertrager nach einem der Ansprüche 1 bis 7, **dadurch gekennzeichnet,** daß der Rohrkern zylindrisch ist.

9. Rohrkernübertrager nach einem der Ansprüche 1 bis 8, **dadurch gekennzeichnet,** daß die Maxima der eine qualitativ etwa gleiche Frequenzabhängigkeit aufweisenden relativen Permeabilitätskonstanten der beiden Halbschalen des Rohrkerns bei unterschiedlichen Frequenzen liegen.

10. Rohrkernübertrager nach einem der Ansprüche 1 bis 9, **dadurch gekennzeichnet,** daß wenigstens eine der beiden Halbschalen (2) jedes Rohrkerns in der der anderen Halbschale (3) zugewandten Stirnfläche (10) eine quer zur Rohrkernachse angeordnete Ausnehmung (30) zum Durchführen wenigstens einer Leiterbahn (32) aufweist.

11. Rohrkernübertrager nach einem der Ansprüche 1 bis 9, **dadurch gekennzeichnet,** daß wenigstens eine der beiden Halbschalen (2, 3) in zwei durch einen Spalt zum Durchführen wenigstens einer Leiterbahn voneinander getrennte Halbschalenteile (33, 34, 35, 36) aufgeteilt ist.

12. Rohrkernübertrager nach Anspruch 11, **dadurch gekennzeichnet,** daß die Halbschalenteile (33, 34 und/oder 35, 36) unterschiedliche relative Permeabilitätskonstanten aufweisen und daß die Signale eines höheren Frequenzbereiches über das (die) Halbschalenteil(e) (33 und/oder 35) mit der geringeren und die Signale eines tieferen Frequenzbereiches über das (die) Halbschalenteil(e) (34 und/oder 36) mit der höheren relativen Permeabilitätskonstanten ausgekoppelt wird.

13. Rohrkernübertrager nach einem der Ansprüche 1 bis 12, **dadurch gekennzeichnet,** daß der Rohrkern ein Mehrfachlochkern ist.

## Claims

1. High frequency transformer with transformer windings formed in printed technology for printed high frequency circuits disposed on clad carrier boards, in particular for collective antenna installations, which comprises a two-part ferrite core through which pass limbs respectively for each of the apertures of the carrier board, parts of which ferrite core are mechanically connected to each other,
**characterised in that** the ferrite core is formed as a tubular core with two half shells (2, 3) which are separated from each other by a narrow gap (14) formed between their mutually facing end surfaces (10), the size of which gap is dimensioned such that in the case of high frequencies up to about 3 GHz the loss resistance is reduced but at low frequencies above about 40 MHz the total inductance is only influenced to an insignificant degree.

2. Tubular core transformer according to claim 1, characterised in that the mutually facing end surfaces (10) of the half shells (2, 3) are adhered to each other.

3. Tubular core transformer according to claim 2, characterised in that the adhesion is carried out by machine within the framework of SMD assembly.

4. Tubular core transformer according to claim 2 or 3, characterised in that the quantity or positioning of the adhesive (12) is decided in such a way that, when the half shells (2, 3 ) are put together, a part of the adhesive leaks over the outer and/or inner edge of the end surfaces (10) of the half shells (2, 3) and produces an adhesive connection of the tubular core to the carrier board (4).

5. Tubular core transformer according to one of claims 2 to 4, characterised in that the end surface (10) of one half shell (2) is flush with the surface (11) of the assembly side of the carrier board (4) on which the SMD components (7) are disposed.

6. Tubular core transformer according to one of claims 1 to 5, characterised in that the outer surface of each of the half shells (2, 3) comprises a flat portion (13) in the apex region.

7. Tubular core transformer according to one of claims I to 6, characterised in that the limbs (8) comprise a straight region of which the length corresponds at least to the thickness of the carrier board (4).

8. Tubular core transformer according to one of claims 1 to 7, characterised in that the tubular core is cylindrical.

9. Tubular core transformer according to one of claims 1 to 8, characterised in that the maximums of the relative permeability constants of the two half shells of the tubular core, which comprise a qualitatively approximately equal frequency dependency, are at different frequencies.

10. Tubular core transformer according to one of claims 1 to 9, characterised in that at least one of the two half shells (2) of each tubular core comprises, in the end surface (10) facing the other half shell (3), an aperture (30), disposed transverse to the axis of the tubular core, for the passage of at least one track (32).

11. Tubular core transformer according to one of claims I to 9, characterised in that at least one of the two half shells (2, 3 ) is divided into two half shell parts (33, 34, 35, 36) separated from each other by a gap for the passage of at least one track.

12. Tubular core transformer according to claim 11, characterised in that the half shall parts (33, 34 and/or 35, 36) comprise different relative permeability constants and that the sigals of a higher frequency range is [sic] decoupled by means of the half shell part(s) (33 and/or 35) with the lower relative permeability constant and the signals of a lower frequency range is [sic] decoupled by means of the half shell part(s) (34 and/or 36) with the higher relative permeability constant.

13. Tubular core transformer according to one of claims 1 to 12, characterised in that the tubular core is a multiply perforated core.

## Revendications

1. Transmetteur haute fréquence équipé d'enroulements transmetteurs réalisés selon la technique d'impression, pour des circuits haute fréquence imprimés, disposés sur des platines support scellées, en particulier pour des installations d'antennes collectives, présentant un noyau en ferrite divisé en deux parties, traversant par des branches un évidement respectif de la platine support, noyau dont les parties sont reliées ensemble mécaniquement, caractérisé en ce que le noyau en ferrite est réalisé sous la forme d'un noyau tubulaire ayant deux demi-coques (2, 3), séparées l'une de l'autre par un intervalle (14) mince constitué entre leurs faces frontales (10) tournées l'une vers l'autre, intervalle dont la valeur est telle que, pour des hautes fréquences, allant jusqu'à environ 3 GHz, il se produit une limitation de la résistance de perte, pour les basses fréquences, supérieures à environ 40 MHz, cependant l'inductivité globale n'étant influencée que de façon insensible.

2. Transmetteur à noyau tubulaire selon la revendication 1, caractérisé en ce que les faces frontales (10) tournées l'une vers l'autre des demi-coques (2, 3) sont collées ensemble.

3. Transmetteur à noyau tubulaire selon la revendication 2, caractérisé en ce que le collage est effectué de façon mécanisée, dans le cadre d'un équipement SMD (éléments montés en surface).

4. Transmetteur à noyau tubulaire selon la revendication 2 ou 3, caractérisé en ce que l'adhésif (13) est choisi en quantité ou en positionnement de manière qu'une partie de celui-ci, lors de l'assemblage des demi-coques (2, 3), sorte du bord extérieur et/ou intérieur des faces frontales (10) des demi-coques (2, 3) et établissent une liaison collée entre le noyau tubulaire et la platine support (4).

5. Transmetteur à noyau tubulaire selon l'une des revendications 2 à 4, caractérisé en ce que la face frontale (10) d'une demi-coque (2) est disposée sur les composants SMD (7) de façon affleurée avec la surface (11) du côté équipement de la platine support (4).

6. Transmetteur à noyau tubulaire selon l'une des revendications 1 à 5, caractérisé en ce que la face extérieure de la demi-coque (2, 3) présente dans chaque zone de sommet un tronçon plan (13).

7. Transmetteur à noyau tubulaire selon l'une des revendications 1 à 6, caractérisé en ce que les branches (8) présentent une zone rectiligne dont la longueur correspond au moins à l'épaisseur de la platine support (4).

8. Transmetteur à noyau tubulaire selon l'une des revendications 1 à 7, caractérisé en ce que le noyau tubulaire est cylindrique.

9. Transmetteur à noyau tubulaire selon l'une des revendications 1 à 8, caractérisé en ce que les maxima des constantes de perméabilité relative, présentant une relation de fréquence qualitativement à peu près identique, des deux demi-coques du noyau tubulaire, sont situés à des fréquences différentes.

10. Transmetteur à noyau tubulaire selon l'une des revendications 1 à 9, caractérisé en ce qu'au moins l'une des demi-coques (2) de chaque noyau tubulaire présente, dans la face frontale (10) tournée vers l'autre demi-coque (3), un évidement (30) disposé transversalement par rapport à l'axe du noyau tubulaire, destiné à laisser passer au moins une piste conductrice (32).

11. Transmetteur à noyau tubulaire selon l'une des revendications 1 à 9, caractérisé en ce qu'au moins l'une des deux demi-coques (2, 3) est subdivisée en deux par un intervalle destiné à laisser le passage à au moins une piste conductrice des parties de demi-coques (33, 34, 35, 36) séparées les unes des autres.

12. Transmetteur à noyau tubulaire selon la revendication 11, caractérisé en ce que les parties de demi-coque (33, 34 et/ou 35, 36) présentent des constantes de perméabilité relatives différentes, et en ce que les signaux d'une plage de fréquences supérieures sont désaccouplés par l'intermédiaire de la (les) partie(s) de demi-coque (33 et/ou 35) ayant les constantes de perméabilité relative plus faibles et les signaux d'une plage de fréquences plus basses sont désaccouplés par l'intermédiaire de la (les) partie(s) de demi-coque (34 et/ou 36) ayant les constantes de perméabilité relatives plus élevées.

13. Transmetteur à noyau tubulaire selon l'une des revendications 1 à 12, caractérisé en ce que le noyau tubulaire est un noyau à plusieurs trous.
